# DEMANDE DE BREVET EUROPEEN

(11) **EP 0 841 696 A1**
(43) Date de publication de la demande: **13.05.1998**
(21) Numéro de dépôt: 97402580.1
(22) Date de dépôt: 30.10.1997
(51) Int. Cl.: H01L 23/49, H01L 21/56

(54) **Procédé d'enrobage de fils de connexion de pastilles à semi-conducteurs de puissance**

(30) Priorité: 07.11.1996 FR 9613593
(71) Demandeur: GEC ALSTHOM TRANSPORT SA, 75116 Paris (FR)
(72) Inventeur: Chave, Jacques, 69003 Lyon (FR)
(74) Mandataire: Gosse, Michel

(57) **Abrégé**

La présente invention porte sur un procédé d'enrobage des fils de connexion de pastilles à semi-conducteurs de puissance au moyen d'un matériau d'enrobage, caractérisé en ce que ledit matériau d'enrobage est un matériau inerte du type polymère de haute pureté.

## Description

La présente invention concerne les pastilles semi-conducteurs de puissance, en général, et porte, plus particulièrement, sur un procédé d'enrobage des fils de connexion de pastilles à semi-conducteurs de puissance, ainsi que sur un fil de connexion de pastilles à semi-conducteurs de puissance ainsi enrobé et sur une pastille à semi-conducteurs de puissance connectée à de tel fils.

Le transistor IGBT est devenu le composant de puissance essentiel pour les équipements convertisseur d'énergie de commande de moteurs dans le domaine de la traction électrique.

Leur principal intérêt est dû au fait qu'ils sont susceptibles de fonctionner aux hautes fréquences, mais également à la simplicité de leur circuit de commande également désigné sous le nom de circuit allumeur.

Pour réaliser des IGBT à fort courant, des modules à haute fiabilité et assemblant plusieurs pastilles en parallèle doivent être développés.

Du fait que ces modules sont composés de différents matériaux, avec différents coefficients d'expansion thermique, des stress thermiques sont induits dans les assemblages brasés.

De tels stress existent également dans les fils d'aluminium soudés par ultrasons, également désignés par le terme de "bondings".

Ces fils de connexion ont pour fonction de collecter les différents potentiels sur la face supérieure des composants.

La dégradation des joints brasés a fait l'objet de nombreuses investigations de la part des chercheurs mais la fiabilité des fils de connexion durant les tests de cyclage en fatigue thermique n'est pas bien comprise aujourd'hui.

En fait, plusieurs modes de casse de ces fils apparaissent durant les essais de vieillissement accéléré selon que la source d'énergie provient du semi-conducteur ou de son environnement et selon la fréquence des stress thermiques, c'est-à-dire selon la capacité thermique des matériaux de l'empilage que l'on désire solliciter.

Il est reconnu aujourd'hui que lors d'essais de fatigue thermique accélérés pour des périodes d'environ 0,04 Hz avec de très fortes variations de température de jonction Δ Tj ≈ 90°C, alors qu'en fonctionnement réel on présume que Δ Tj ≤ 40°C, une délamination de la soudure des fils soudés par ultrasons apparaît par dilatation différentielle et donc cisaillement à la surface du silicium (α_{Si} = 4,1ppm/°C et α AI = 25,3 ppm/°C).

Ainsi les connections des émetteurs sont mises progressivement en circuit ouvert sur les premières pastilles défaillantes.

Une conséquence de ce qui précède est une surcharge en courant des pastilles connectées en parallèles, ce qui provoque la destruction en chaîne des pastilles et donc la destruction du module.

Par contre, lorsque la période est de l'ordre de 1Hz et que les taux de charge sont élevés en courant, seul le fil soudé par ultrasons est sollicité et la défaillance apparaît par une casse du fil au talon de sa soudure.

Cette casse du fil soudé par ultrasons est due aux flexions répétées sur un fil qui se dilate et possède deux points d'encrages fixes.

Les procédés de l'art antérieur consistent à mouler les pastilles de semi-conducteurs de puissance par coulage d'un gel silicone, souple à l'état polymérisé.

Un inconvénient des procédés de l'art antérieur, du fait qu'ils font appel à un gel silicone, est que le gel silicone reste souple à l'état dit de "gel" et que le gel silicone ne permet pas la fonction de maintien mécanique par rigidification des soudures des fils soudés, seule l'atténuation des vibrations peut être considérée.

Aussi un but de l'invention est-il un procédé d'enrobage des fils de connexion de pastilles à semi-conducteurs de puissance ne présentant pas les inconvénients des procédés de l'art antérieur et, plus particulièrement, à procurer une durée de vie améliorée aux fils de connexion de pastilles à semi-conducteurs de puissance.

Un autre but de l'invention est un fil de connexion de pastilles à semi-conducteurs de puissance ainsi enrobé et une pastille à semi-conducteurs de puissance connectée à de tel fils pour lesquels les deux modes de défaillance existant dans les fils de connexion et dans les pastilles à semi-conducteurs de puissance de l'art antérieur sont atténués.

Conformément à l'invention, le procédé d'enrobage des fils de connexion de pastilles à semi-conducteurs de puissance au moyen d'un matériau d'enrobage, se caractérise en ce que ledit matériau d'enrobage est un matériau inerte du type polymère de haute pureté permettant une amélioration de la durée de vie desdits fils de connexion de pastilles à semi-conducteurs de puissance.

Le procédé d'enrobage des fils de connexion de pastilles à semi-conducteurs de puissance de l'invention satisfait également à l'une au moins des caractéristiques suivantes:
- ledit matériau d'enrobage est semblable au polyimide utilisé pour la passivation du semi-conducteur,
- ledit matériau d'enrobage est séché à une température de l'ordre de 80°C puis polymérisé à des températures de l'ordre de 180 à 280°C de manière à contraindre mécaniquement le fil de connexion, essentiellement ses extrémités soudées, dans une gaine rigide.

Le procédé selon l'invention s'applique également auxdites pastilles à semi-conducteurs de puissance.

Conformément à une caractéristique de l'invention, le fil de connexion de pastilles à semi-conducteurs de puissance se caractérise en ce qu'il est enrobé conformément au procédé d'enrobage de l'invention.

Conformément à une caractéristique de l'invention, le fil de connexion de pastilles à semi-conducteurs de puissance se caractérise en ce que lesdites extrémités soudées desdits fils de connexion sont enrobées conformément au procédé d'enrobage selon l'une quelconque des revendications précédentes.

Conformément à une caractéristique de l'invention, la pastille à semi-conducteurs de puissance se caractérise en ce qu'elle est enrobée, en totalité ou partiellement, conformément au procédé d'enrobage de l'invention.

Un avantage du procédé d'enrobage des fils de connexion de pastilles à semi-conducteurs de puissance de l'invention est de multiplier la durée de vie des dispositifs à semi-conducteurs par un facteur 1,5 à 2 pour une même technologie d'assemblage.

D'autres buts, caractéristiques et avantages de l'invention apparaîtront à la lecture de la description du procédé d'enrobage des fils de connexion de pastilles à semi-conducteurs de puissance.

Conformément à une caractéristique essentielle du procédé d'enrobage des fils de connexion de pastilles à semi-conducteurs de puissance de l'invention, le matériau d'enrobage est un matériau inerte du type polymère de haute pureté.

Un tel matériau d'enrobage est de préférence semblable au polyimide utilisé pour la passivation du semi-conducteur.

Un tel matériau d'enrobage selon l'invention permet, une fois séché à une température de l'ordre de 80°C puis polymérisé à des températures de l'ordre de 180 à 280°C, de contraindre mécaniquement le fil de connexion dans une gaine rigide.

La polymérisation d'un tel matériau d'enrobage induit indirectement un recuit des fils de connexion aluminium, une fois soudés sur les pastilles.

Cette étape du procédé d'enrobage des fils de connexion de l'invention provoque un accroissement de la taille des grains cristallins de l'aluminium à l'interface soudé.

Un avantage important de cette étape du procédé d'enrobage des fils de connexion de l'invention est de renforcer la tenue à la fatigue thermique des soudures des fils de connexion aluminium sur les pastilles.

En effet, il ressort des études empiriques de l'art antérieur du phénomène provocant la défaillance des soudures des fils de connexion aluminium par ultrasons sur semi-conducteur de puissance, que des fissures se propagent le plus souvent dans le fil de connexion lui-même aux interfaces situés entre les grains fins, issus de la soudure ultrasonore, et les grains larges, dues à la nature du coeur des fils de connexion.

Il est raisonnable de penser que les stress thermiques sont plus élevés à ces interfaces du fait que les joints de grains sont les sites les plus faibles dans les fils de connexion aluminium.

Cette frontière fragile est donc atténuée par le procédé d'enrobage des fils de connexion de l'invention du fait du recuit de polymérisation.

Des essais de fatigue thermique ont été conduits sur des assemblages de pastilles IGBT intégrés en technologie hybride de puissance avec un enrobage du type polyamide au niveau des fils de connexion.

Une amélioration significative de la fiabilité des fils de connexion enrobés selon le procédé d'enrobage de l'invention a été mise en évidence.

Ces tests de vieillissement accéléré avec des périodes d'environ 0,04 Hz et de très fortes variations de température de jonction, ΔTⱼ ≈ 80°C, ont conduit à une durée de vie de 110000 cycles, ce qui correspond pour un fonctionnement réel où ΔTⱼ ≤ 40°C à une durée de vie de plus de 10 puissance 7 cycles.

Le procédé d'enrobage de l'invention est susceptible de s'appliquer uniquement aux extrémités soudées des fils de connexion aux pastilles à semi-conducteurs de puissance.

Le procédé d'enrobage de l'invention est susceptible de s'appliquer avantageusement, en totalité ou partiellement, aux pastilles à semi-conducteurs de puissance.

L'enrobage au moyen d'un matériau inerte du type polymère de haute pureté concerne alors non seulement les fils de connexion mais également les pastilles à semi-conducteurs de puissance.

Un avantage du procédé d'enrobage des pastilles à semi-conducteurs de puissance de l'invention est une protection spécifique des matériaux semi-conducteurs de puissance contribuant à une passivation supplémentaire de la surface de ces matériaux semi-conducteurs, d'où une protection climatique et antipollution contre l'environnement et une protection diélectrique vis-à-vis des tensions et surtensions en fonctionnement réel.

A titre d'exemple, le polymère utilisé dans le procédé d'enrobage de l'invention est avantageusement un produit du style HIMAL HL-1210 commercialisé par HITACHI CHEMICAL.

La viscosité de ce polymère, 183 cps à 25°C, est telle que le polymère se dépose facilement à la seringue par dispenser en venant couvrir d'une fine toile (50 à 100 µ) la pastille de silicium et ses fils de connexion, en particulier leurs extrémités soudées.

Une fois polymérisé, la dureté Rockwell de ce polymère est de l'ordre de 107 (sur l'échelle M, selon la méthode de test ASTM D785) équivalente à une dureté de crayon 5H.

A l'état polymérisé, ce polymère est également un excellent diélectrique pour les températures de fonctionnement des systèmes électroniques considérés.

## Revendications

1. Procédé d'enrobage des fils de connexion de pastilles à semi-conducteurs de puissance, plus particulièrement les extrémités soudées desdits fils de connexion, au moyen d'un matériau d'enrobage, caractérisé en ce que le matériau d'enrobage est un matériau inerte du type polymère de haute pureté permettant une amélioration de la durée de vie desdits fils de connexion de pastilles à semi-conducteurs de puissance.

2. Procédé selon la revendication 1, dans lequel ledit matériau d'enrobage est semblable au polyimide utilisé pour la passivation du semi-conducteur.

3. Procédé selon l'une quelconque des revendications 1 ou 2, dans lequel ledit matériau d'enrobage est séché à une température de l'ordre de 80°C puis polymérisé à des températures de l'ordre de 180 à 280°C de manière à contraindre mécaniquement le fil de connexion, essentiellement ses extrémités soudées, dans une gaine rigide.

4. Procédé selon l'une quelconque des revendications 1 à 3, appliqué également auxdites pastilles à semi-conducteurs de puissance.

5. Fil de connexion de pastilles à semi-conducteurs de puissance, caractérisé en ce que ledit fil de connexion est enrobé conformément au procédé d'enrobage selon l'une quelconque des revendications précédentes.

6. Fil de connexion de pastilles à semi-conducteurs de puissance, caractérisé en ce que lesdites extrémités soudées desdits fils de connexion sont enrobées conformément au procédé d'enrobage selon l'une quelconque des revendications précédentes.

7. Pastille à semi-conducteurs de puissance, caractérisée en ce que ladite pastille est enrobée, en totalité ou partiellement, conformément au procédé d'enrobage selon l'une quelconque des revendications précédentes.
